# EUROPÄISCHE PATENTSCHRIFT

(11) **EP 1 860 342 B1**
(45) Veröffentlichungstag und Bekanntmachung des Hinweises auf die Patenterteilung: **03.07.2013**
(21) Anmeldenummer: 06010795.0
(22) Anmeldetag: 26.05.2006
(51) Int. Cl.: F16F 15/00, G03F 7/20

(54) **Schwingungsisolationssystem**
Vibration isolation system
Système anti-vibrations

(43) Veröffentlichungstag der Anmeldung: 28.11.2007
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- EP-A- 1 566 710
- JP-A- 2001 027 280
- JP-A- 2001 044 109
- JP-A- 2005 061 588
- US-A1- 2004 135 979

## Beschreibung

### Gebiet der Erfindung

Die Erfindung betrifft ein Schwingungsisolationssystem, insbesondere ein aktives Schwingungsisolationssystem, bei Welchem, eine Regeleinrichtung mit Aktoren zur aktiven Unterdrückung von Schwingungen verbunden ist.

### Hintergrund der Erfindung

Schwingungsisolationssysteme sind bekannt. So zeigt beispielsweise die EP 9273 80 B1 ein SchwingungsisolationsSystem mit Fluidlagern, auf welchem ein Lithographiegerät schwingungsisoliert gelagert ist. Die JP 2001027280 zeigt ein System und ein Verfahren vgl. Oberbegriff des Anspruchs 6 bzw. des Anspruchs 1, bei welchem eine Vibrationen verursachende Maschine einen Sensor aufweist und über Aktoren den von der Maschine verursachten Schwingungen entgegen gewirkt wird.

Die Anforderungen an Schwingungsisolationssysteme werden immer höher. Mit zunehmender Miniaturisierung insbesondere von Halbleiterbauelementen werden Fertigungstoleranzen benötigt, welche nur von Maschinen erreicht werden, welche schwingungsisoliert gelagert sind.

Bekannte Schwingungsisolationssysteme mit einer aktiven Regelung verzichten dabei auf die Berücksichtigung der zu isolierenden Last. Das System ist in der Regel so ausgelegt, dass der Tisch, auf dem eine zu isolierende Last, insbesondere eine Maschine gelagert ist, möglichst schwingungsisoliert gelagert wird. Schwingungen, die von der zu isolierenden Last selbst ausgehen, insbesondere in Folge von Arbeitsabläufen einer schwingungsisoliert gelagerten Maschine, werden können dabei höchsten indirekt über Positionssensoren an der zu isolierenden Last erfasst werden.

Auch kann die zu lagernde Maschine selbst Sensoren und Aktoren aufweisen, mittels deren Positionsänderungen ausgeglichen werden. Eine derartige Regelung einer zu lagernden Maschine hat aber den Nachteil, dass sie zum einen recht aufwändig ist und zum anderen nicht abgestimmt auf eine aktive Regelung des Schwingungsisolationssystems arbeitet. So kann es vorkommen, dass die aktive Regelung des Schwingungsisolationssystems und die gelagerte Maschine gegenläufige Bewegungen ausführen, wodurch sich insbesondere Eigenschwingungen bestimmter Bauteile sogar verstärken können.

### Aufgabe der Erfindung

Der Erfindung liegt demgegenüber die Aufgabe zugrunde, ein Schwingungsisolationssystem mit einer aktiven Regelung bereitzustellen, bei welcher die Isolationswirkung gegenüber dem Stand der Technik verbessert ist.

Insbesondere ist Aufgabe der Erfindung, ein Schwingungsisolationssystem bereitzustellen, bei welchem maschineninterne Stellglieder zur Reduzierung von schwingungsbedingten Störungen mitverwendet werden.

Dabei ist eine weitere Aufgabe der Erfindung die Steuerung derartiger Stellglieder an der zu lagernden Last auf die sonstige Arbeitsweise des Schwingungsisolationssystems abzustimmen.

### Zusammenfassung der Erfindung

Die Aufgabe der Erfindung wird durch ein Schwingungsisolationssystem sowie durch ein Verfahren zur Schwingungsisolation nach der unabhängigen Ansprüchen 1 und 6 erreicht.

Bevorzugte Ausführungsformen und Weiterbildungen der Erfindung sind den jeweiligen Unteransprüchen zu entnehmen.

Die Erfindung sieht ein Schwingungsisolationssystem vor, welches zumindest eine auf einem Lager schwingungsisoliert gelagerte Aufnahmeeinrichtung umfasst. Unter "Aufnahmeeinrichtung" im Sinne der Anmeldung werden Vorrichtungen jeder Art verstanden, auf welchen eine zu lagernde Last, beispielsweise eine Maschine angeordnet werden kann. Es handelt sich dabei typischerweise um einen schwingungsisoliert gelagerten Tisch, aber auch andere Ausführungsformen sind denkbar.

Das Schwingungsisolationssystem umfasst zumindest einen Sensor, der Positionsänderungen der Aufnahmeeinrichtung oder eine auf der Aufnahmeeinrichtung gelagerten Last an zumindest einer Stelle und zumindest in einer Raumrichtung erfasst.

Vorzugsweise werden zur Erfassung von Positionsänderungen berührungslos arbeitende Sensoren wie kapazitiv oder induktiv arbeitende Sensoren verwendet.

Mit derartigen Sensoren können, wie es bei einer bevorzugten Ausführungsform der Erfindung vorgesehen ist, Bewegungen in allen Freiheitsgraden erfasst werden.

Die Sensoren sind vorzugsweise an der Aufnahmeeinrichtung, etwa in Nähe der Lager, angeordnet.

Im Sinne der Erfindung ist es aber auch möglich, Sensoren bereitzustellen, welche Positionsänderungen einer gelagerten Maschine erfassen.

Weiter umfasst das Schwingungsisolationssystem eine Regeleinrichtung, welche mit dem Sensor verbunden ist. Diese Regeleinrichtung dient der aktiven Regelung des Schwingungsisolationssystems. So kann die Regeleinrichtung beispielsweise mit der Druckluftzufuhr von Luftlagern verbunden sein. Falls sich die zu lagernde Last erhöht, wird über die Regeleinrichtung, welche mit einem entsprechenden Regelventil verbunden ist, der Druck in der Luftzuführung erhöht und so ein Niveauausgleich geschaffen.

Gemäß der Erfindung umfasst die Regeleinrichtung zumindest einen Ausgang zum Ansteuern eines Stellgliedes einer auf der Aufnahmeeinrichtung gelagerten Maschine. Unter einer Maschine wird jedes aktive Bauelement verstanden, welches auf der Aufnahmeeinrichtung angeordnet werden kann. Über den zumindest einen Ausgang der Regeleinrichtung wird ein in der Aufnahmeeinrichtung schon vorgesehenes oder nachträglich implementiertes Stellglied angesteuert und so im Rahmen einer aktiven Regelung des Schwingungsisolationssystems auftretenden Bewegungsänderungen entgegengewirkt.

So ist es möglich, dass die Steuerung einer gelagerten Maschine bei der Berechnung der aktiven Regelung berücksichtigt wird. Die Regeleinrichtung kann, unter Einbeziehung sonstiger für die aktive Regelung generierten Signale, weitere Kompensationssignale generieren, über welche die gelagerte Maschine selbst Bewegungsänderungen entgegenwirkt.

So kann beispielsweise die Belichtungseinheit eines Lithographiegerätes, um verbleibende Restschwingungen einer auf der Aufnahmeeinrichtung gelagerten Platte zu kompensieren, aktiv nachgesteuert werden. Die Genauigkeit kann so erheblich erhöht werden.

Bei der Erfindung ist die Regeleinrichtung mit zumindest einem Aktor, der Positionsänderungen der zu isolierenden Last und/oder der Aufnahmeeinrichtung entgegenwirkt, verbunden. Über derartige Aktoren können insbesondere hochfrequente Schwingungen auch mit recht geringer Schwingungsamplitude kompensiert werden.

Vorzugsweise werden berührungslos angreifende Aktoren, wie Magnet- oder kapazitiv arbeitende Aktoren verwendet. Alternativ sind durch ihre kompakte Bauweise auch Piezoaktoren gut geeignet.

Bei einer Weiterbildung der Erfindung sind in der Regeleinrichtung Kennfelder und/oder Kennlinien speicherbar, die die Reaktion des Systems auf eine Anregung, insbesondere aufgrund einer Bewegung einer Maschine und/oder eine Änderung der Last repräsentieren. Es lässt sich so in einer Art Datenbank die Reaktion des Schwingungsisolationssystems auf die Änderung von Randbedingungen abspeichern.

Die Regeleinrichtung kennt die Reaktion des Systems auf eine bestimmte Störung oder Anregung. So kann die Regeleinrichtung aktiv einer darauf resultierenden Bewegungsänderung entgegenwirken, ohne dass es überhaupt zu dieser Bewegungsänderung kommt. Die Kennfelder können dabei Reaktionen des Systems etwa auf äußere Störeinflüsse wie Schwingungen, Luftdruckschwankungen oder auf Bewegungen gelagerter Maschinenelemente umfassen. Die Kompensationswirkung des Schwingungsisolationssystems wird so wesentlich verbessert.

Bei der Erfindung umfasst die Maschine eine Elektronenstrahlquelle. Dabei kann es sich beispielsweise um eine Wafer-Inspektionsmaschine handeln, welche mittels eines Rasterelektrodenstrahls einen Wafer auf Fehler untersucht. Es sind bei derartigen Geräten äußerst hohe Genauigkeiten erforderlich und aufgrund des Abstandes der Elektronenstrahlquelle zu einem Probentisch führen bereits geringe Schwingungen des Probentischs oder der Elektronenstrahlquelle zu einer Verschlechterung des gewonnenen Bildes.

Über die Regeleinrichtung kann, wie es gemäß der Erfindung vorgesehen ist, eine Ablenkspule des Elektronenstrahls beeinflusst werden und so der Elektronenstrahl Positionsänderungen eines Probentischs nachgefahren werden.

Alternativ oder in Kombination kann, wie es gemäß der Erfindung vorgesehen ist, der Probentisch selbst, auf welchem die Wafer unter der Elektronenstrahlquelle hindurch geführt werden, aktiv von der Regeleinrichtung angesteuert werden.

Die Regeleinrichtung generiert Kompensationssignale, mittels der die Relativpositionierung von Probentisch und Elektronenstrahlquelle aufeinander verbessert werden.

Nach der Erfindung umfasst das Schwirigungsisolationssystem eine Maschine zur Belichtung von Halbleiterbauelementen. Dabei wird ein Probentisch, auf welchem das zu belichtende Halbleiterbauelement angeordnet ist, aktiv angesteuert.

Vorzugsweise ist die Aufnahmeeinrichtung auf Fluidlagern, insbesondere auf Luftlagern gelagert, welche vorzugsweise ebenfalls durch die Regeleinrichtung angesteuert werden.

Bei einer bevorzugten Ausführungsform umfasst die Regeleinrichtung analoge und/oder digitale Ausgänge zur Ansteuerung einer Maschine, welche vom Benutzer je nach verwendeter Maschine konfiguriert werden können, so dass auf dem System unterschiedliche Maschinen gelagert werden können. Die Ausgänge werden dabei vorzugsweise über einen Computer konfiguriert.

Die Erfindung umfasst des Weiteren ein Verfahren zum Betrieb eines aktiven Schwingungsisolationssystems, wobei die Positionsänderung einer zu lagernden Last in zumindest einer Raumrichtung mittels eines Sensors gemessen wird.

Gemäß der Erfindung wird ein Stellglied einer schwingungsisoliert gelagerten Maschine einer Regeleinrichtung, die mit dem zumindest einen Sensor verbunden ist, angesteuert.

So werden die Maschinensteuerung und die aktive Steuerung des Schwingungsisolationssystems aufeinander abgestimmt.

Bei einer Weiterbildung der Erfindung werden in der Regeleinrichtung Kennlinien oder Kennfelder gespeichert, über die eine Änderung von Randbedingungen, insbesondere Änderungen der zu lagernden Last oder äußeren Störeinflüssen aktiv entgegen geregelt werden kann.

Bei einer Weiterbildung der Erfindung werden die Kennlinien oder Kennfelder beim Betrieb automatisch aufgezeichnet oder angepasst.

Die aktive Regelung lernt so, wie das System auf Änderungen von Randbedingungen reagiert. So kann das System in der Folge schon im Vorfeld Kompensationssignale generieren, mit welchen Positionsänderungen aufgrund geänderter Randbedingungen schon im Vorfeld aktiv entgegen gewirkt wird.

### Kurzbeschreibung der Zeichnungen

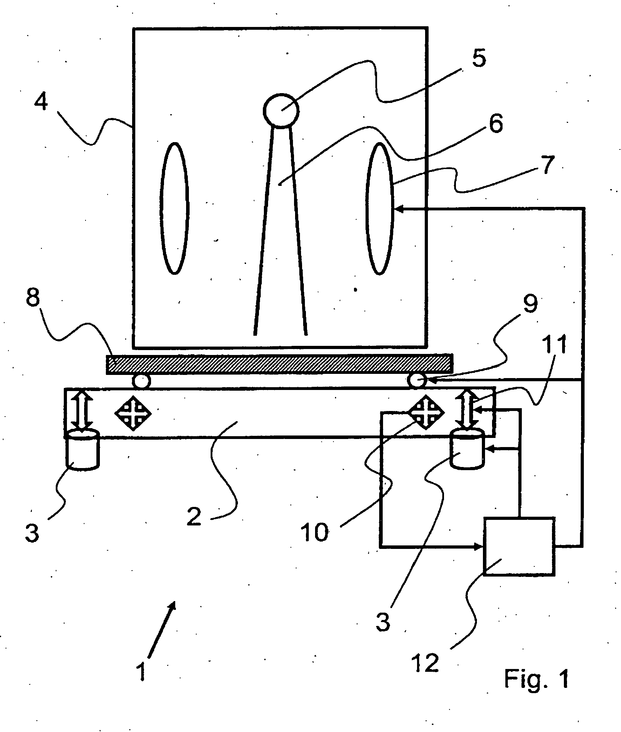

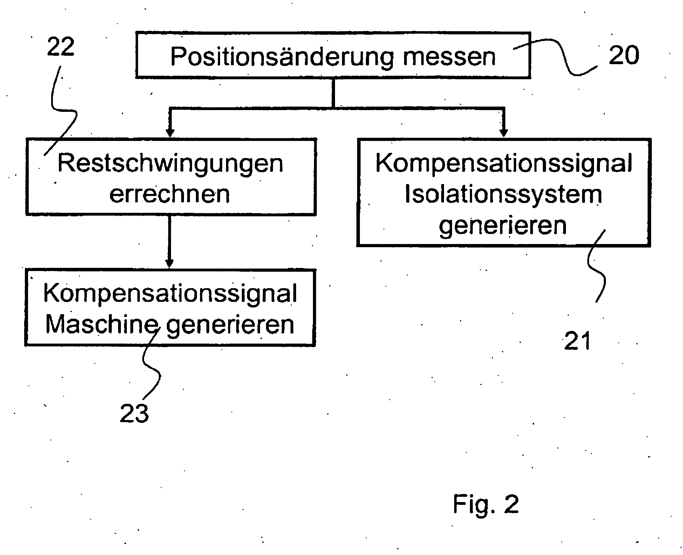

Die Erfindung soll im Folgenden an Hand der Zeichnungen Fig. 1 und Fig. 2 näher erläutert werden.
- Fig. 1: zeigt schematisch eine Ausführungsform eines erfindungsgemäßen Schwingungsisolationssystems,
- Fig. 2: zeigt schematisch die wesentlichen Schritte eines erfindungsgemäßen Verfahrens zur Schwingungsisolation.

### Detaillierte Beschreibung der Zeichnungen

Bezug nehmend auf das schematisch dargestellte Ausführungsbeispiel eines Schwingungsisolationssystems 1 gemäß Fig. 1 sollen die wesentlichen Elemente des Schwingungsisolationssystems 1 näher erläutert werden.
Das Schwingungsisolationssystem 1 umfasst eine Aufnahmeeinrichtung 2 in Form eines Tisches, welcher auf Luftlagern 3 schwingungsisoliert gelagert ist. Auf der Aufnahmeeinrichtung 3 ist ein Probentisch 8 angeordnet, welcher seinerseits auf Servomotoren 9 auf der Aufnahmeeinrichtung 2 ruht.

Über dem Probentisch 8 ist eine Wafer-Inspektionsmaschine 4 angeordnet. Die Wafer-Inspektionsmaschine 4 umfasst eine Elektronenstrahlquelle, deren Elektronenstrahl 6 über Ablenkspulen 7 gesteuert werden kann. Der Probentisch 8 muss während der Untersuchung eines Wafers (nicht dargestellt) immer genau ausgerichtet zur Wafer-Inspektionsmaschine 4 stehen. Bereits geringe Schwingungen oder Bewegungen des Probentischs 8 oder der Wafer-Inspektionsmaschine 4 führen zu einem unscharfen Bild.

Das Schwingungsisolationssystem 1 umfasst eine aktive Regelung. Dazu ist eine Regeleinrichtung 12 vorgesehen, welche mit Positionssensoren 10, welche an verschiedenen Stellen angeordnet sein können, unter anderem auch an der Wafer-Inspektionsmaschine (nicht dargestellt) verbunden.

Über die Sensoren werden Positionsänderungen erfasst und an die Regeleinrichtung 12 weitergeleitet.

Die Regeleinrichtung 12 steuert zum einen die Luftzufuhr der Luftlager 3 und zum anderen die berührungslos an der Aufnahmeeinrichtung 2 angreifende Aktoren 11.

Über die Aktoren 11 kann insbesondere auch hochfrequenten Schwingungen mit niedriger Schwingungsamplitude entgegen gesteuert werden, während über die Luftzufuhr der Luftlager 3 Schwingungen mit langsamer Amplitude entgegen gewirkt wird und zum anderen ein Niveauausgleich geschaffen wird.

Erfindungsgemäß ist die Regeleinrichtung 12 darüber hinaus mit Stellgliedern der gelagerten Maschine verbunden. In diesem Ausführungsbeispiel ist die Regeleinrichtung zum einen mit den Ablenkspulen 7 der Wafer-Inspektionsmaschine 4 und zum anderen mit den Servomotoren 9 des Probentischs 8 verbunden.

Ausgehend von den gewonnenen Sensordaten errechnet die Regeleinrichtung, in der Kennfelder, die repräsentieren wie das System auf Änderung der Randbedingungen reagiert, gespeichert sind, verbleibende Restschwingungen.

Um diese Restschwingungen weiter zu kompensieren, erzeugt die Regeleinrichtung 12 Kompensationssignale, mit welchen die Ablenkspulen 7 und die Servomotoren 9 angesteuert werden und so die verbleibenden Restschwingungen weitgehend kompensiert werden.

Im Ergebnis wird eine erheblich verbesserte Bildqualität der Wafer-Inspektionsmaschine 4 erreicht.

Bezug nehmend auf Fig. 2, welche ein Flussbild eines erfindungsgemäßen Verfahrens darstellt, sollen die wichtigsten Verfahrensschritte kurz erläutert werden.

In einem ersten Schritt werden über einen Sensor Positionsänderungen gemessen 20. Die Messung von Positionsänderungen kann an beliebiger Stelle des Schwingungsisolationssystems, also sowohl an verschiedenen Stellen einer Aufnahmeeinrichtung als auch an Bauteilen einer gelagerten Maschine selbst gemessen werden. vorzugsweise greifen die Sensoren dabei berührungslos an.

An Hand der gemessenen Positionsänderungen werden zum einen Kompensationssignale für das Isolationssystem generiert 21. Diese Kompensationssignale umfassen beispielsweise die Steuerung der Fluidzufuhr von Fluidlagern und/oder die Ansteuerung von Aktoren zur aktiven Schwingungsisolation,

Gleichzeitig errechnet das System verbleibende Restschwingungen 22. An Hand der errechneten Restschwingungen wird ein Kompensationssignal für die gelagerte Maschine generiert 23, wodurch eine erhöhte Fertigungsgenauigkeit erreicht werden kann.

Es ist dabei besonders von Vorteil, dass die Steuerung der gelagerten Maschine in die Steuerung des Isolationssystems eingebunden ist. So wird erreicht, dass Maschine und Schwingungsisolationssystem nicht gegenläufig zueinander arbeiten.

### Bezugszeichenliste

- 1: Schwingungsisolationssystem
- 2: Aufnahmeeinrichtung
- 3: Luftlager
- 4: Wafer-Inspektionsmaschine
- 5: Elektronenstrahlquelle
- 6: Elektronenstrahl
- 7: Ablenkspule
- 8: Probentisch
- 9: Servomotor
- 10: Sensor
- 11: Aktor
- 12: Regeleinrichtung

- 20: Positionsänderung messen
- 21: Kompensationssignal für das Isolationssystem errechnen
- 22: Restschwingungen errechnen
- 23: Kompensationssignal für die Maschine generieren

## Patentansprüche

1. schwingungsisolationssystem (1), umfassend eine auf zumindest einem Lager (3) schwingungsisoliert gelagerte Aufnahmeeinrichtung (2), einen Probentisch (8),
zumindest einen Sensor (10), der die Position der Aufnahmeeinrichtung (2) an .zumindest einer Stelle in zumindest einer Raumrichtung erfasst, und zumindest eine Regeleinrichtung (12), die mit dem zumindest einen Sensor (10) verbunden ist, wobei die Regeleinrichtung (12) mit zumindest einem Aktor (11), der Positionsänderungen der Aufnahmeeinrichtung entgegen wirkt, verbunden ist,
wobei die Regeleinrichtung (12) über zumindest einen Ausgang zum Ansteuern eines Stellglieds mit einem Stellglied einer auf der Aufnahmeeinrichtung gelagerten Maschine (4), welche eine Elektronenstrahlquelle (5) umfasst, verbunden ist, **dadurch gekennzeichnet, dass**
über die Regeleinrichtung (12) eine Ablenkspule (7) des Elektronenstrahls (6) beeinflussbar und so der Elektronenstrahl (6) Positionsänderungen des Probentisches (8) nachfahrbar ist

2. Schwingungsisolationssystem (1)
nach Anspruch 1,
**dadurch gekennzeichnet, dass** in der Regeleinrichtung (12)
Kennfelder und/oder Kennlinien, die die Reaktion des Systems auf eine Anregung, insbesondere aufgrund einer Bewegung der auf dem Schwingungsisolationssystem (1) gelagerten Maschine, und/oder eine Änderung der Last repräsentieren, speicherbar sind.

3. Schwingungsisolationssystem (1)
nach einem der vorstehenden Ansprüche,
**dadurch gekennzeichnet, dass** die Aufnahmeeinrichtung (2) auf Fluidlagern gelagert ist.

4. Schwingungsisolationssystem (1)
nach dem vorstehenden Anspruch,
**dadurch gekennzeichnet, dass** die Fluidlager über die Regeleinrichtung (12) ansteuerbar sind.

5. Schwingungsisolationssystem (1)
nach einem der vorstehenden Ansprüche,
**dadurch gekennzeichnet, dass** die Regeleinrichtung (12) analoge und/oder digitale Ausgänge zur Ansteuerung einer Maschine aufweist.

6. Verfahren zum Betrieb eines aktiven Schwingungsisolationssystems (1) mit zumindest einer auf zumindest einem Lager (3) schwingungsisoliert gelagerten Aufnahmeeinrichtung (2), einem Probentisch (8), einer Regeleinrichtung (12), die mit zumindest einem sensor (10) verbunden ist, wobei die Regeleinrichtung (12) mit zumindest einem Aktor (11), der Positionsänderungen der Aufnahmeeinrichtung entgegen wirkt, verbunden ist, wobei die Regeleinrichtung (12) über zumindest einen Ausgang zum Ansteuern eines Stellglieds mit einem Stellglied einer auf der Aufnahmeeinrichtung gelagerten Maschine (4), welche eine Elektronenstrahlquelle (5) umfasst, verbunden ist,
wobei
mit dem zumindest einen Sensor (10) die Position der Aufnahmeeinrichtung (2) an zumindest einer Stelle in zumindest einer Raumrichtung erfasst wird, **dadurch gekennzeichnet, dass** der Probentisch (8), auf welchem die Wafer unter der Elektronenstrahlquelle (5) hindurchgeführt werden, aktiv von der Regeleinrichtung (12) angesteuert ist, wobei die Regeleinrichtung Kompensationssignale generiert, mittels der die Relativpositionen von Probentisch und Elektronenstrahlquelle aufeinander verbessert werden.

7. Verfahren zum Betrieb eines aktiven Schwingungsisolationssystems (1) nach dem vorstehenden Anspruch,
**dadurch gekennzeichnet, dass** in der Regeleinrichtung (12) Kennlinien und/oder Kennfelder gespeichert werden, über die eine Änderung der gelagerten Last und/oder auftretenden Störeinflüssen aktiv entgegen geregelt werden kann.

8. Verfahren zum Betrieb eines aktiven Schwingungsisolationssystems (1) nach dem vorstehenden Anspruch,
**dadurch gekennzeichnet, dass** die Kennlinien oder Kennfelder beim Betrieb des Schwingungsisolationssystems automatisch aufgezeichnet und/oder angepasst werden.

## Claims

1. Vibration isolation system (1), including a receiving device (2) mounted on at least one bearing (3) so as to be isolated with respect to vibrations, a sample table (8),
at least one sensor (10) which detects the position of the receiving device (2) at at least one point in at least one spatial direction, and at least one adjusting device (12) which is connected to the at least one sensor (10), wherein the adjusting device (12) is connected to at least one actuator (11) which counteracts position changes of the receiving device,
wherein the adjusting device (12) is connected via at least one output for actuation of a control member to a control member of a machine (4) which is mounted on the receiving device and which includes an electron beam source (5), **characterised in that**
by means of the adjusting device (12) a deflection coil (7) of the electron beam (6) can be influenced and thus the electron beam (6) can follow position changes of the sample table (8).

2. Vibration isolation system (1) as claimed in claim 1, **characterised in that** characteristic diagrams and/or characteristic curves which represent the reaction of the system to an excitation, in particular owing to a movement of the machine mounted on the vibration isolation system (1), and/or a change in the load can be stored in the adjusting device (12).

3. Vibration isolation system (1) as claimed in any one of the preceding claims, **characterised in that** the receiving device (2) is mounted on fluid bearings.

4. Vibration isolation system (1) as claimed in the preceding claim, **characterised in that** the fluid bearings can be actuated via the adjusting device (12).

5. Vibration isolation system (1) as claimed in any one of the preceding claims, **characterised in that** the adjusting device (12) has analogue and/or digital outputs for actuation of a machine.

6. Method for operating an active vibration isolation system (1) having at least one receiving device (2) mounted on at least one bearing (3) so as to be isolated with respect to vibrations, a sample table (8), an adjusting device (12) which is connected to at least one sensor (10), wherein the adjusting device (12) is connected to at least one actuator (11), which counteracts position changes of the receiving device, wherein the adjusting device (12) is connected via at least one output for actuation of a control member to a control member of a machine (4) which is mounted on the receiving device and which includes an electron beam source (5),
wherein by means of the at least one sensor (10) the position of the receiving device (2) is detected at at least one point in at least one spatial direction,
**characterised in that** the sample table (8) on which the wafers are passed through under the electron beam source (5) is actively actuated by the adjusting device (12), wherein the adjusting device generates compensation signals by means of which the relative positions of the sample table and electron beam source with respect to each other are improved.

7. Method for operating an active vibration isolation system (1) as claimed in the preceding claim, **characterised in that** in the adjusting device (12) characteristic diagrams and/or characteristic curves are stored, by means of which a change in the mounted load and/or disrupting influences which arise can be actively counter-adjusted.

8. Method for operating an active vibration isolation system (1) as claimed in the preceding claim, **characterised in that** the characteristic curves or characteristic diagrams are automatically recorded and/or adapted during operation of the vibration isolation system.

## Revendications

1. Système d'isolation contre les vibrations (1), comprenant un dispositif de réception (2) monté de manière isolée contre les vibrations sur au moins un palier (3), une table à échantillons (8),
au moins un capteur (10) détectant la position du dispositif de réception (2) à au moins un emplacement dans au moins une direction spatiale, et
au moins un dispositif de régulation (12) relié au au moins un capteur (10), ledit dispositif de régulation (12) étant relié à au moins un actionneur (11) s'opposant aux variations de position du dispositif de réception,
le dispositif de régulation (12) étant relié par au moins une sortie pour la commande d'un composant de réglage à un composant de réglage d'une machine (4) montée sur le dispositif de réception, laquelle comprend une source de rayonnement électronique (5),
**caractérisé en ce qu'**une bobine de déviation (7) du faisceau électronique (6) peut être influencée par le dispositif de régulation (12), le faisceau électronique (6) pouvant ainsi suivre les variations de position de la table à échantillons (8).

2. Système d'isolation contre les vibrations (1) selon la revendication 1,
**caractérisé en ce que** des diagrammes caractéristiques et/ou des courbes caractéristiques représentant la réaction du système à une excitation, en particulier suite à un déplacement de la machine montée sur le système d'isolation contre les vibrations (1), et/ou une variation de la charge, sont mémorisables dans le dispositif de régulation (12).

3. Système d'isolation contre les vibrations (1) selon l'une des revendications précédentes,
**caractérisé en ce que** le dispositif de réception (2) est monté sur des paliers fluidiques.

4. Système d'isolation contre les vibrations (1) selon la revendication précédente,
**caractérisé en ce que** les paliers fluidiques peuvent être commandés au moyen du dispositif de régulation (12).

5. Système d'isolation contre les vibrations (1) selon l'une des revendications précédentes,
**caractérisé en ce que** le dispositif de régulation (12) présente des sorties analogiques et/ou numériques pour la commande d'une machine.

6. Procédé de fonctionnement d'un système actif d'isolation contre les vibrations (1) comprenant au moins un dispositif de réception (2) monté de manière isolée contre les vibrations sur au moins un palier (3), une table à échantillons (8), un dispositif de régulation (12) relié à au moins un capteur (10), ledit dispositif de régulation (12) étant relié à au moins un actionneur (11) s'opposant aux variations de position du dispositif de réception, le dispositif de régulation (12) étant relié par au moins une sortie pour la commande d'un composant de réglage à un composant de réglage d'une machine (4) montée sur le dispositif de réception, laquelle comprend une source de rayonnement électronique (5),
la position du dispositif de réception (2) à au moins un emplacement dans au moins une-direction spatiale étant détectée par le au moins un capteur (10), **caractérisé en ce que** la table à échantillons (8) sur laquelle les tranches sont passées sous la source de rayonnement électronique (5), est commandée activement par le dispositif de régulation (12), ledit dispositif de régulation générant des signaux de compensation au moyen desquels les positions relatives de la table à échantillons et de la source de rayonnement électronique sont affinées l'une sur l'autre.

7. Procédé de fonctionnement d'un système actif d'isolation contre les vibrations (1) selon la revendication précédente,
**caractérisé en ce que** des diagrammes caractéristiques et/ou des courbes caractéristiques sont mémorisés dans le dispositif de régulation (12), permettant une régulation active en opposition à une variation de la charge montée et/ou à des influences perturbatrices formées.

8. Procédé de fonctionnement d'un système actif d'isolation contre les vibrations (1) selon la revendication précédente,
**caractérisé en ce que** les diagrammes caractéristiques ou les courbes caractéristiques sont automatiquement enregistrés et/ou adaptés pendant le fonctionnement du système d'isolation contre les vibrations.
